# EUROPEAN PATENT APPLICATION

(11) **EP 0 778 292 A2**
(43) Date of publication of application: **11.06.1997**
(21) Application number: 96119156.6
(22) Date of filing: 29.11.1996
(51) Int. Cl.: C08F 8/46, G03F 7/021

(54) **Method for the production of anhydride modified polyvinyl acetals useful for photosensitive compositions**

(30) Priority: 04.12.1995 US 566763
(71) Applicant: Bayer Corporation, Pittsburgh, PA 15219-2502 (US)
(72) Inventor: Koletar, Gabor I., Berkeley Heights, New Jersey 07922 (US); Dhillon, Major S., Belle Mead, New Jersey 08502 (US); Alam, Mahfuzul, Bridgewater, New Jersey 08807 (US); Sprintschnik, Gerhard, Branchburg, New Jersey 08853 (US); Wanat, Stanley F., Scotch Plains, New Jersey 07076 (US)
(74) Representative: Ramon, Charles Lucien

(57) **Abstract**

A method for producing polymers which are anhydride modifications of polymers containing hydroxyl groups, such as polyvinyl acetal polymers. Such modified polymers are useful as binders for photosensitive compositions used to prepare photographic elements such as lithographic printing plates, color proofing films and photoresists. The binder is the reaction product of an intramolecular anhydride of an organic polycarboxylic acid with a polymer containing hydroxyl groups, and which does not contain other functional groups which are capable of reaction with acid anhydrides. The reaction is conducted in a solvent composition free of hydroxyl containing solvents such as methyl ethyl ketone and ethylene glycol monomethyl ether.

## Description

### BACKGROUND OF THE INVENTION

### Field of the Invention

The present invention relates to polymers which are anhydride modifications of polymers containing hydroxyl groups, such as polyvinyl acetal polymers. Such modified polymers are particularly useful to prepare photographic elements such as lithographic printing plates, color proofing films and photoresists.

### Description of the Prior Art

It is well known in the art that polymers may be used as binders in the production of photosensitive compositions. However, the majority of such polymers are limited in their usefulness by the need to make the polymer, to formulate photosensitive compositions with the polymer and to develop photosensitive elements produced with such compositions in solutions containing substantial amounts of organic solvents. Some organic solvents are undesirable since they may be explosive and/or emit large amounts of undesired toxic and environmentally harmful vapors in use.

Photosensitive compositions must be formulated to maximize their beneficial properties including oleophilicity, developability, longest possible length of printing run, and absence of composition redeposit back onto developed nonimage areas. In this regard, photosensitive mixtures which contain polyvinyl acetals, such as polyvinyl formal or polyvinyl butyral as binders for diazonium salt polycondensation product photosensitive compounds are known from U.S. patent 3,867,147. These binders are sufficiently oleophilic to produce lithographic printing plates having a long print run. However, such printing plates must be developed in solutions which contain large quantities of organic solvents. It is naturally desirable to develop printing plates without the use of organic solvents since vapors and waste waters originating from these developers are disadvantageous. It is known to produce printing plates which can be developed with aqueous acidic or alkaline solutions by suspending removed non-image areas of photosensitive layers in the developer in the form of flakes or small particles. However, such particles tend to be redeposited back on the non-image areas of the plate, rendering the plates unusable.

U.S. patent 4,387,151 discloses printing plates prepared from photosensitive mixtures of condensation products of diazonium salts and other nonphotosensitive compounds in combination with polymeric binders which have alkenylsulfonylurethane groups. These can be developed with aqueous, alkaline solutions without organic solvents. However, lithographic printing plates made from these compositions produce light hardened layers having unsatisfactory ink receptivity. It is known to produce resins for photosensitive applications containing 5 to 40% polyvinyl acetal, 5 to 35% azide-aryl substituted polyvinyl acetal, 1 to 45% polyvinyl acetate and 1 to 60% polyvinyl alcohol groups, as shown in U.S. patent 4,413,091. Interpolymers for the stabilization of formaldehyde solutions wherein the interpolymer is composed of vinyl acetate, vinyl acetal and vinyl alcohol, are shown in U.S. patent 4,085,079. Each of these resins, when used in photosensitive elements, must be developed with developers which contain organic solvents. All of the above patents are incorporated herein by reference.

U.S. patent 4,631,245, which is also incorporated herein by reference, teaches an anhydride modified polyvinyl acetal polymer which is most useful as a binder for photosensitive composition layers which can be developed with neutral or weakly alkaline, aqueous solutions and produce printing plates with a high print run performance and good ink receptivity. These photosensitive mixtures yield image areas with good oleophilic properties, resistance to abrasion during printing and etching resistance. Unfortunately, both the preparation of the polymer and the preparation of a photosensitive composition from the polymer are taught to require the use of undesirable methyl ethyl ketone (MEK) and methyl cellosolve (MC) i.e., ethylene glycol monomethyl ether solvents. The present invention improves on the foregoing method of preparing these latter polymers by using a non-hydroxyl containing solvent composition which is free of MC and MEK. It has been found that propylene glycol methyl ether acetate (PGMEA) as a solvent for formation of the polymer, and a blend of PGMEA, propylene glycol methyl ether (PGME), and optionally butyrolactone (BL0) and tetrahydrofuran (THF) for producing the photosensitive coating, allow both the polymer and the overall photosensitive coating to be formed from a MC/MEK free solvent system. The polymers and photosensitive coatings prepared in these improved solvent systems have advantages. The vapor levels present at coating equipment are well below the lower explosive limits (LEL). In addition, there is no need to use respirators when coating as is required with the use of a MC/MEK containing solvent system. In particular, production of anhydride modified polyvinyl acetal resins in PGMEA and a photosensitive coating in a solvent system of PGME/PGMEA/BLO/THF allows coating much below the LEL, and vapor levels are below those requiring use of a respirator. This translates into lower costs and better efficiency of coating operations. The photosensitive composition can still be developed by means of practically solvent-free, neutral or alkaline aqueous solutions, and yields printing plates producing large print runs and having a good ink receptivity.

### SUMMARY OF THE INVENTION

The invention provides a method for the preparation of a modified polymer useful as a binder for photosensitive compositions. The method comprises dispersing a hydroxy containing polymer in a sufficient amount of a non-hydroxy containing solvent composition which is free of methyl ethyl ketone and ethylene glycol monomethyl ether, to uniformly disperse the hydroxy containing polymer under conditions such that the solvent composition does not emit an amount of combustible vapors, which when mixed with air exceeds 25% of the lower explosive limit of the solvent composition; and reacting the hydroxy containing polymer with an anhydride in the presence of a catalytic amount of a tertiary amine catalyst.

The invention also provides a method for producing a photosensitive composition which comprises forming the above modified polymer; dissolving the formed modified polymer in a second solvent composition without isolation of the modified polymer, and subsequently uniformly admixing therewith at least one light sensitive component selected from the group consisting of a diazonium compound, a photopolymerizable composition, an azido compound or a quinonediazide compound to form a photosensitive composition.

A photosensitive element may be produced by coating the above formed photosensitive composition onto a substrate and drying. A photographic image may be produced by imagewise exposing the photosensitive element to actinic radiation and then removing the nonimage portions of the photosensitive composition from the substrate while leaving the image portions of the photosensitive composition on the substrate.

### DETAILED DESCRIPTION OF THE PREFERRED EMBODIMENT

The modified polymers according to the invention are produced by using a hydroxy containing polymer, preferably a synthetic polymer containing hydroxyl groups and having no further functional groups which are capable of reaction with acid anhydrides. Synthetic polymers containing hydroxy groups, which can be used include, in particular, polymers having vinyl alcohol units. Also useful are epoxy resins and saponified epoxy resins, copolymers of allyl alcohol or higher molecular weight unsaturated alcohols, polyhydroxyalkyl acrylates and polyhydroxyalkyl methacrylates and similar polymers. Suitable polymers containing vinyl alcohol units include partially saponified polyvinyl esters, polyvinyl acetals having free hydroxy groups and corresponding reaction products of copolymers with vinyl ester units or vinyl acetal units or vinyl alcohol units. The preferred polyvinyl acetals are polyvinyl butyrals and polyvinyl formals which can be prepared simply or are commercially available. The preferred polyvinyl acetals are the Butvars and Formvar which are commercially available from Monsanto, and the polyvinyl acetals described in U.S. patent 4,670,507, which is incorporated herein by reference. The most preferred polyvinyl acetal is Mowital B60T, available commercially from Hoechst AG, which contains about 69-71 mol% vinyl acetal units, about 5 mol% vinyl acetate units and about 24-27 mol% vinyl alcohol units.

The starting polymer is reacted with an acid anhydride, preferably an intramolecular anhydride of an organic polycarboxylic acid. The acid anhydride according to the invention is preferably derived from a dicarboxylic or tricarboxylic acid, particularly from a dicarboxylic acid and may have one, two or several rings. Particularly preferred binders are obtained by reacting with acid anhydrides corresponding to one of the Formulae I, II or III: 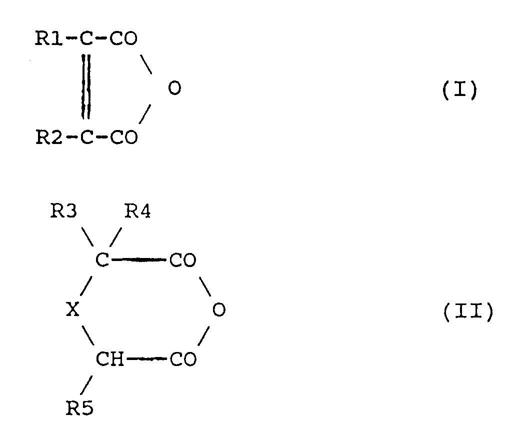 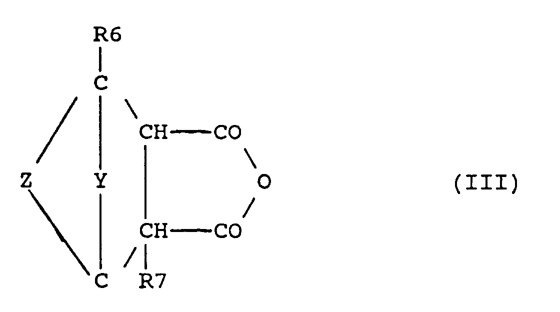 wherein R1 and R2 individually are selected from hydrogen atoms and alkyl groups, or are interconnected to form an aromatic or heteroaromatic, unsubstituted or substituted and optionally partially hydrogenated five-membered or six-membered ring which may be fused with up to two aromatic or cycloaliphatic rings, R3, R4 and R5 individually are selected from hydrogen atoms and alkyl groups, further, R3 and R5 can be interconnected to form an unsubstituted or substituted, saturated or unsaturated aliphatic ring which, inclusive of X, may have five or six ring members, R6 and R7 are selected from hydrogen atoms and alkyl groups, X is a single bond, an unsubstituted or substituted 1,1-alkylene group or 1,1-cycloalkylene group, an oxygen atom or a sulfur atom, Y is an oxygen atom or a sulfur atom, a 1,1- or 1,2-alkylene group or a 1,2-alkenylene group, which may optionally be fused with an aromatic or cycloaliphatic ring, and Z is selected from ring members required for the completion of a saturated or unsaturated, unsubstituted or substituted ring, this ring optionally being fused with up to two aromatic or cycloaliphatic rings.

If R1, R2, R3, R4, R5, R6, or R7 stand for alkyl groups, the latter generally have from 1 to 4, preferably 1 or 2, carbon atoms. Substituents which may be bonded to the aromatic or cycloaliphatic rings include, for example, alkyl groups, alkoxy groups, halogen atoms, nitro groups or carboxyl groups.

Examples of suitable acid anhydrides include maleic anhydride and derivatives thereof, for example, dimethyl maleic anhydride or citraconic anhydride; succinic anhydride and derivatives thereof, for example, methyl succinic anhydride; glutaric anhydride and derivatives thereof, for example, 3-methyl glutaric anhydride, 3,3-tetramethylene glutaric anhydride, or camphoric acid anhydride; 3-oxa-glutaric anhydride and derivatives thereof; phthalic anhydride and substitution products thereof, for example, chloro, nitro, or carboxyphthalic anhydride, partially or completely hydrogenated phthalic anhydrides, for example, hexahydrophthalic anhydride or cyclohexene-1,2-dicarboxylic acid anhydride; naphthalene-2,3-dicarboxylic acid anhydride or naphthalene-1,8-dicarboxylic acid anhydride and substitution products thereof; pyridine-o-dicarboxylic acid anhydride and substitution products thereof; pyrazine-o-dicarboxylic acid anhydride and substitution products thereof; furan-o-dicarboxylic acid anhydride or furan-2,5-dicarboxylic acid anhydride, the substitution products thereof and the partially or completely hydrogenated derivatives thereof; thiophene-o-dicarboxylic acid anhydride or thiophene-2,5-dicarboxylic acid anhydride, the substitution products thereof and the completely or partially hydrogenated derivatives thereof; dicyclic or polycyclic anhydrides formed by the Diels-Alder reaction of a diene with maleic anhydride, for example, the addition products from furan, anthracene, cyclohexadiene-1,3 or cyclopentadiene with maleic anhydride.

The products obtained from the reaction with maleic anhydride, phthalic anhydride, succinic anhydride or 3-oxa-glutaric anhydride are preferred.

The molecular weight of the modified polymers according to the invention can vary within wide limits. Generally, they have average molecular weights in the range of from about between 5,000 to about 200,000 or above, preferably from about 10,000 to about 100,000. The acid numbers of the binders can generally be in the range of from about 5 to about 80, preferably from about 10 to about 70. The acid numbers of the polymers are lower than the acid numbers of the binders which have heretofore been used in photosensitive compositions of the same generic type, as far as these compositions were suitable and intended for the development with aqueous solutions. The reaction between acid anhydride and polymer containing hydroxy groups proceeds very smoothly and is a quantitative reaction in many cases. As a consequence, it is possible to exactly and reproducibly adjust the desired acid number of the binder, for the ultimate application of a particular developer.

An important feature of the invention is that the reaction be run in non-hydroxy containing solvent composition, for example, propylene glycol monomethyl ether acetate. The solvent composition is free of methyl ethyl ketone and ethylene glycol monomethyl ether. The reaction is conducted under conditions such that the solvent composition does not emit an amount of combustible vapors which when mixed with ambient air exceeds 25% of the lower explosive limit of the solvent composition. The lower explosive or lower flammability limit (LEL) is the lowest proportion of combustible vapor, which when mixed with air, will cause an explosion or flammability in the presence of an ignition source. The LEL may be measured, for example, by a model FFA Sensor System which is commercially available from Control Instruments Corporation of Fairfield, New Jersey.

The reaction is conducted in the presence of as tertiary amine catalyst, such as triethylamine. In general, from 0.5 to 20 parts by weight of anhydride, from 1,000 to 3,000 parts by weight of solvent and from 0.5 to 5 parts by weight of tertiary amine are used per 100 parts by weight of polymer containing hydroxy groups. The modified polymer is optionally isolated by washing with water or dissolving and reprecipitating. Although the products can be dried before they are used in photosensitive layers such isolation is not necessary.

The modified polymers of the invention are used as binders in combination with various photosensitive substances, such as diazonium salt poly-condensation products, photopolymerizable mixtures, azido derivatives or quinonediazides. In the preferred embodiment, the modified polymer is not isolated. Rather, the photosensitive component is blended directly in the modified polymer forming mixture with the optional addition of any other compatible solvent composition which is capable of dissolving the photosensitive composition components. The preferred method is to remove a portion of the PGMEA, and add a like amount of PGME together with the light sensitive component and optionally to add tetrahydrofuran and butyrolactone.

The polymers which are used in this way yield layers which can be developed easily and without staining and which, depending on the nature of the composition, can be developed with water, aqueous solutions with small amounts of inorganic salts and/or surfactants added, or with aqueous alkaline solutions. The layers are remarkable for comparatively high resistance to abrasion good ink receptivity and storage stability, and can therefore be employed for numerous application possibilities, in particular for the preparation of lithographic plates, silkscreen stencils and photoresists.

In such applications, the dried photosensitive layers contain about 10 to 90, preferably about 20 to 75% by weight of the polymers according to the invention.

As negative-working light-hardenable substances it is possible to employ virtually all the known compounds provided they are compatible with the polymeric matrix. For example, diazonium salt polycondensation products, particularly condensation products of aromatic diazonium salts capable of condensation with aldehydes, more particularly condensation products of diphenylamine-4-diazonium salts with formaldehyde, are very highly suitable. Advantageously, co-condensation products are, however, employed which, in addition to the diazonium salt units, contain further, non-photosensitive units which are derived from compounds capable of condensation, for example aromatic amines, phenols, phenol ethers, aromatic thioethers, aromatic hydrocarbons, aromatic heterocyclic compounds or organic acid amides. Such condensation products are disclosed in U.S. patents 3,867,147, 3,679,419 and 3,849,392. The compositions according to the present invention generally comprise from 5 to 90, preferably from 10 to 70, percent by weight of diazonium compound, and from 95 to 10, preferably from 90 to 30, percent by weight of polymeric binder.

Suitable diazonium salt polycondensation products are condensation products of condensible aromatic diazonium salts, for example, of diphenylamine-4-diazonium salts with aldehydes, preferably formaldehyde. Further particularly advantageous polycondensation products are obtained by condensing an optionally substituted diphenylamine diazonium salt, first with an aromatic compound R'-O-CH2-B and then with an aromatic compound R'-O-CH2-B-CH2-O-R', R' being a hydrogen atom, an alkyl or aliphatic acyl radical and B being the radical of one of the above listed compounds capable of condensation. To stabilize the photosensitive composition, it is advantageous to add a compound having an acid character. Compounds which can be used include mineral acids and strong organic acids, with phosphoric acid, sulfuric acid, perchloric acid, boric acid or p-toluene sulfonic acid being preferred. Phosphoric acid is a particularly suitable acid. Plasticizers, adhesion promoters, dyes, pigments and color precursors can also be added to the compositions. The types and quantities of such additions depend upon the field of application for which the photosensitive composition is intended. In principle, care must be taken that the added substances do not absorb an excessive portion of the actinic light which is required for cross-linking, because this would result in a reduction of the practical sensitivity to light.

Photopolymerizable mixtures composed of a polymerizable monomer or oligomer and photoinitiators can also advantageously be employed as photosensitive constituents in the mixture according to the invention, in particular in the field of application of printed circuits.

Suitable polymerizable compounds are, for example, disclosed in U.S. Pat. Nos. 2,760,683 and 3,060,023. Examples are acrylic or methacrylic acid esters of polyhydric alcohols such as trimethylolpropane triacrylate, polyethylene glycol diacrylate, neopentyl glycol diacrylate, 2,2-dimethylolbutan-3-ol diacrylate, pentaerythritol tri- or tetraacrylate and also the corresponding methacrylates. Furthermore, acrylates or methacrylates which contain urethane groups, and also acrylates or methacrylates of polyesters containing hydroxyl groups are suitable. Finally, prepolymers containing allyl or vinyl groups are suitable, in particular, monomers or oligomers being preferred which contain at least two polymerizable groups per molecule. The polymerizable compounds may, in general, be contained in a quantity of about 5 to 50, preferably about 10% to 35% by weight, referred to the nonvolatile constituents, in the mixture according to the invention.

Numerous substances may be used in the photosensitive mixture according to the invention as photoinitiators. Examples are benzoins, benzoin ethers, polynuclear quinones such as 2 ethylanthraquinone, acridine derivatives such as 9-phenylacridine or benzoacridines, phenazine derivatives such as 9,10-dimethylbenz[a]phenazine, quinoxaline or quinoline derivatives such as 2,3-bis(4-methoxyphenyl)quinoxaline or 2-styrylquinoline, quinazoline compounds or acylphosphine oxide compounds. Useful photoinitiators of this type are, for example, hydrazones, mercapto compounds, pyrylium and thiopyrylium salts, synergistic mixtures with ketones or hydroxyketones and dyestuff redox systems may be suitable. Particularly preferred are photoinitiators which have trihalomethyl groups which can be cleaved by light, in particular suitable compounds from the triazine or thiazoline series. The photoinitiators are in general added in quantitative proportions of about 0.1 to 15, preferably of about 0.5% to 10% by weight, referred to the nonvolatile constituents of the mixture.

For certain applications low- or high-molecular weight azido derivatives are particularly suitable as photosensitive compounds, low-molecular weight azido compounds containing at least two azido groups per molecule being preferred. As examples, mention may be made of 4,4'-diazidostilbenes, 4,4'-diazidobenzophenones, 4,4'-diazidobenzalacetophenones, 4,4'-diazido benzalacetones or 4,4' diazidobenzalcyclohexanones. The photosensitivity of such azido compounds may optionally be intensified by using suitable sensitizers, for example 1,2-benzanthraquinone. Furthermore those polyfunctional azides are also suitable whose individual absorption has been displaced by conjugation with double bonds in the molecule in a manner such that no additional sensitization is necessary in the exposure. Further suitable azido compounds are known from U.S. patent 2,848,328. The quantitative proportion of the azido derivative in the mixture is in general from about 5 to about 60, preferably from about 10% to about 40% by weight, referred to the total content of nonvolatile constituents. Finally, low molecular diazo compounds such as p-quinonediazide or p-iminoquinonediazide can be used as photosensitive compounds. Such mixtures are, however, because of the low photosensitivity, not preferred. The quantity of the low-molecular diazo compounds may in general be about 5 to 60, preferably about 10% to 40% by weight, referred to the nonvolatile constituents of the mixture.

Furthermore, depending on the nature of the photosensitive compounds, the following additives may be added to the photosensitive coating solution: a dyestuff to render the photosensitive layer visible on the base material; an acid, preferably phosphoric acid, to stabilize the diazonium salt, and a contrast former which effects an intensification of the color change in the layer during exposure, sensitizers, inhibitors which suppress the thermal polymerization, or hydrogen donors. These additional components may be present in amounts of from about 0 to about 12 % by weight of the non-solvent coating composition parts.

In addition, plasticizers, pigments, further resin components, etc. may be added to the photosensitive mixture. For further processing, the solutions obtained are filtered in order to remove constituents which may not be dissolved, and applied in a manner known, per se, for example, with a doctor blade or by spinning, to a suitable base material and dried. Suitable base materials are, polymeric films, silicon wafers, and aluminum alloys which have been grained mechanically or electrochemically and optionally anodized and post-treated, aluminum clad films or other hydrophilized films, films coated with copper by vapor deposition or multimetal foils. It is particularly preferred to pretreat the aluminum used for this purpose in the usual manner, for example, by a mechanical, chemical or electrochemical roughening process which is, optionally, followed by an anodic oxidation. A further treatment of this support material, for example, with polyvinyl phosphonic acid, alkali metal silicate, phosphate, hexafluorozirconate, chromate, borate, polyacrylamide and cellulose derivatives is advantageous. The nature of the application depends to a large degree on the desired layer thickness of the photosensitive layer, the layer thicknesses of the photosensitive layer in general being from about 0.5 to about 200 um.

After adequate drying, the materials can be converted into their respective application form in a manner known, per se by exposure to an image by means of a film mask or, with suitable sensitization, by means of a laser beam and subsequent development. The material is exposed under a exposure mask, using light sources which emit light with the highest possible spectral fraction in the near ultraviolet region. The material can also be exposed by laser irradiation. Suitable lasers for irradiation are shorter-wave lasers, for example, Ar lasers, krypton ion lasers, helium/cadmium lasers, emitting in the region between about 300 and 600 nm and, for some coatings, even CO² lasers, which emit at about 10.6 um, or YAG lasers emitting at about 1.06 um.

Development can be carried out with water, aqueous solutions which optionally contain small quantities of an organic salt and/or surfactants or with aqueous alkali solutions. The type of development preferred in each case depends on the composition of the photosensitive mixture, on the hydroxyl number of the polymer according to the invention and on the application. Those photosensitive mixtures are preferred which can be processed with developers which contain an alkali-metal salt of an aliphatic or araliphatic sulfonic acid, an alkali-metal borate, an alkali-metal phosphate and optionally an alkali-metal salt of an organic aromatic carboxylic acid, for example benzoic acid. Preferred developer solutions are substantially neutral or alkaline aqueous solutions are used, which have a pH value in the range from 6 to 14, preferably from 7.5 to 12, and which contain buffer salts, for example, water-soluble, alkali metal phosphates, silicates, borates, carbonates, acetates or benzoates. Additional constituents used are wetting agents, preferably anionic wetting agents and, if appropriate, water-soluble polymers. The solution can also contain minor amounts, for example, up to 5 percent by weight, preferably not more than 2 percent by weight, or water-miscible organic solvents. It is preferred to use solvents having low volatility, for example, araliphatic alcohols, the vapor pressure of which is of no consequence in the handling of the developer. Development can be performed in the conventional manner by developing machines, dipping, spraying, brushing or wiping-over with a pad.

In some cases it is beneficial to treat the exposed and developed mixture with a preservative. The layer can be additionally consolidated by a thermal post-treatment, which is expedient, in particular, in lithographic printing plate applications. For this purpose, the preserved printing plate is heated to temperatures of from about 180^{o} C. to about 240^{o} C. The duration of this treatment depends on the temperature and varies from about 2 to about 20 minutes. This thermal post-treatment differs from the post treatments of a similar nature described previously insofar as it does not require any addition of a crosslinking agent. It is assumed that the polymers according to the invention eliminate water under these conditions and are converted into polymers with unsaturated side groups which are available for an additional photochemical or thermal crosslinking. It may therefore be expedient to add, additionally, a thermal crosslinker to the photosensitive mixture, for example, an organic peroxide with a scorch temperature of at least 100^{o} C. which is capable above said temperature of forming radicals. Suitable peroxides are peroxy esters, peroxy ketals, bisaralkyl peroxides, dialkyl peroxides and bisdialkyl peroxides. This thermal post-treatment considerably improves the ink receptivity behavior of the photosensitive layer, especially if those polymers are employed which have a high hydroxyl number.

The mixtures according to the invention make it possible to prepare lithographic printing plates which are notable for relatively high print runs, good reproduction properties and storage stability meeting practical requirements. They can be processed easily and without staining using developer solutions which are virtually environmentally neutral. As a result of the thermal post-treatment described above, a substantial increase in the resistance to abrasion can be achieved. Furthermore, they make it possible to prepare resists and stencils with excellent resolution which have an adequate thermal stability and guarantee an adequate storage stability. In this case, very mild, low toxicity or nontoxic developer solutions can be used. Finally, the preparation of silkscreen stencils may also be mentioned as a field of application. Here, the beneficial processing characteristics and the good storage stability of the mixture are particular advantages.

The following non-limiting examples serve to illustrate the invention.

### Example 1 (Comparative)

A 1050 alloy aluminum web was degreased and etched in a sodium hydroxide solution, anodized to an oxide weight of 3.0 g/m² in sulfuric acid, sealed with polyvinyl phosphonic acid and coated with a light sensitive coating. The light sensitive coating includes a diazo resin as described in U.S. Patents 3,867,147 and 3,849,392 and a modified polyvinyl acetal resin as described in U.S. Patent 4,631,245. The coating formulation is given below:

| INGREDIENT | Weight Percent |
|---|---|
| Ethylene glycol methyl ether (methyl Cellosolve) | 57.884 |
| Butyl acetate | 7.748 |
| Tetrahydrofuran (THF) | 14.290 |
| Resin (8.5% in MEK) (US Patent # 4,631,245) | 18.140 |
| Phosphoric acid (85%) | 0.067 |
| PADA (p-azo diphenylamine) | 0.025 |
| Diazo | 1.455 |
| Renol Blue B2G (solid) dispersion | 0.391 |

The formulation for Renol Blue B2G (solid) dispersion is given below:

| Ingredient | Weight Percent |
|---|---|
| Percent Mowital B30H | 50.0 |
| Copper phthalocyanine (Blue B2G) | 50.0 |

The light sensitive coating was applied at a coating weight of 1.0 g/m². The coated plate was exposed to U.V. light (365 nm) through a negative mask for 30 seconds using a Teaneck exposure unit (sold by Teaneck Graphics Systems, Teaneck, New Jersey, using a L1250 UV light source from Oleck Corporation, Irvine, California). The exposed plate was developed in an aqueous developer (sold under the trade name ND-143 by Hoechst Celanese Corporation, Printing Products Division, Branchburg, New Jersey).

ND-143 developer composition is given below:

| Ingredient | Weight percent |
|---|---|
| Potassium hydroxide | 1.4 |
| Potassium tetraborate | 1.0 |
| Poly-n-vinyl-n-methyl acetamide | 0.5 |
| Nonanoic acid | 4.0 |
| Dodecyl benzene sodium sulfonate | 1.4 |
| Sodium hexametaphosphate | 2.0 |
| Phenoxyethanol | 4.0 |
| Water | remainder |

The developed plate provided 250,000 printed press impression. The coating solution described above had a shelf stability of less than 36 hours at room temperature (23^{o}C). Because of the presence of methyl cellosolve in the coating solution, one has to use respirators all the time while working at the coating head.

### Example 2 (Comparative)

A degreased, mechanically grained, etched, anodized and sealed (with polyvinyl phosphonic acid) 1050 alloy was coated with light sensitive coated. The light sensitive diazo is described in US Patents 3,867,147 and 3,849,392. The resin is a modified polyvinyl acetal resin as described in U.S. Patent 4,631,245. The following coating solution was employed:

| Ingredient | Weight Percent |
|---|---|
| Propylene glycol methyl ether (Dowanol PM) | 29.418 |
| Butyrolactone (BLO) | 28.000 |
| Resin (13.74% in MEK) (U.S. Patent 4,631,245) | 35.993 |
| Phosphoric acid (85%) | 0.227 |
| p-azo diphenylamine (PADA) | 0.086 |
| Diazo | 4.946 |
| Renol Blue B2G (solid) dispersion | 1.330 |

The solution shelf stability at room temperature (23^{o}C) was less than 36 hours. The results of LEL (Lower Explosive Levels) monitored ranged from 11% to 60% during the sampling period near the coating head. Because the LEL readings were higher than 25% of the allowed limits, this solution was not a suitable candidate for production.

### Example 3:

A degreased, mechanically grained, etched, anodized and sealed (with polyvinyl phosphonic acid) 1050 alloy was coated with light sensitive coating. The light sensitive coating includes the diazo described in U.S. Patents 3,867,147 and 3,849,392 and the resin is a modified polyvinyl acetal resin as described below:

### Resin in PGMEA/PGME

Charge 156 parts by weight (pbw) propylene glycol methyl ether acetate (PGMEA) into a vessel equipped to protect the contents from moisture. Under good agitation, slowly add 13.9 pbw Mowital B60T resin which has been dried to a moisture content of <1%. Heat slowly, while agitating to 70^{o}C and continue stirring to obtain a clear solution. Add 1.25 pbw maleic anhydride and continue agitation until a clear solution is obtained. Add 0.225 pbw triethyl amine and stir the mixture at 70^{o}C for an additional one hour. Turn off the heat and stirrer and allow the mixture to cool to room temperature (23^{o}C). Decant/drain 78 pbw of solvent from the solid mass which forms during cooling. Save the decanted solvent for the start of the next batch. Add 78 pbw propylene glycol methyl ether and agitate at room temperature until a clear solution is obtained. This resin in PGMEA/PGME obtained above was used to prepare the following light sensitive coating solution. The following coating solution was employed:

| Ingredient | Weight Percent |
|---|---|
| Propylene glycol methyl ether (Dowanol PM) | 37.944 |
| Butyrolactone (BLO) | 18.200 |
| Resin in PGMEA/PGME | 38.700 |
| Phosphoric acid (85%) | 0.178 |
| p-azo diphenylamine (PADA) | 0.068 |
| Diazo (US Patent 3,867,147) | 3.870 |
| Renol Blue B2G (solid) dispersion | 1.040 |

The shelf stability of this coating solution at room temperature was found to more than 5 days. The LEL readings for this solution was in the range of about 3-6%.

The coating was applied to a substrate at a coating weight of 0.5 g/m² to produce lithographic printing plates. The exposed and developed plates when run on a Multi press provided 100,000 printed impressions.

### Example 4

A degreased, mechanically grained, etched, anodized and sealed (with polyvinyl phosphonic acid) 1050 alloy was coated with a light sensitive coating. The light sensitive coating contained a diazo as described in US Patents 3,867,147 and 3,849,392 and a modified polyvinyl acetal resin as described below:

### Resin in PGMEA/PGME

Charge 156 parts by weight (pbw) propylene glycol methyl ether acetate (PGMEA) into a vessel equipped to protect the contents from moisture. Under good agitation, slowly add 13.9 pbw Mowital B60T resin which has been dried to a moisture content of <1%. Heat slowly, while agitating to 90^{o}C and continue stirring to obtain a clear solution. Add 1.25 pbw maleic anhydride and continue agitation until a clear solution is obtained. Add 0.225 pbw triethyl amine and stir the mixture at 90^{o}C for an additional three hours. Turn off the heat and allow the mixture to cool to 80^{o}C. Distill 78 pbw of PGMEA under vacuum. Break the vacuum, cut off heat and start to cool the batch to room temperature. Save the distilled PGMEA solvent for the start of the next batch. Add 78 pbw propylene glycol methyl ether and agitate at room temperature until clear solution. This resin in PGMEA/PGME was used to prepare the light sensitive coating solution. The following coating solution was employed:

| Ingredient | Weight Percent |
|---|---|
| Propylene glycol methyl ether (Dowanol PM) | 34.925 |
| Butyrolactone (BLO) | 12.976 |
| Resin in PGMEA/PGME | 16.411 |
| Phosphoric acid (85%) | 0.163 |
| p-azo diphenylamine (PADA) | 0.062 |
| Diazo (US Patent 3,867,147) | 3.552 |
| Resin in PGMEA/PGME Blue Dispersion | 31.912 |

The formulation for Resin in PGMEA/PGME Blue Dispersion is given below:

| Ingredient | Weight Percent |
|---|---|
| Resin in PGMEA/PGME (this example) | 60.0 |
| Copper phthalocyanine (Blue B2G) | 6.0 |
| Propylene glycol methyl ether (Dowanol PM) | 25.5 |
| Butyrolactone (BLO) | 8.5 |

The shelf stability of this coating solution at room temperature was found to be more than 5 days. The LEL readings for this solution was in the range of 3-6%. The coating was applied at a coating weight of 0.5 g/m². The exposed and developed plates when put on a Multi press provided 100,000 printed impressions.

### Example 5

A degreased, etched, electrochemically grained with alternating current, anodized and sealed (with polyvinyl phosphonic acid) 1050 alloy was coated with a light sensitive coating. The light sensitive coating contained the diazo as described in U.S. Patents 3,867,147 and 3,849,392. The resin used is a modified polyvinyl acetal resin in PGMEA/PGME as described in example 4. The following coating solution was employed:

| Ingredient | Weight Percent |
|---|---|
| Propylene glycol methyl ether (Dowanol PM) | 53.033 |
| Butyrolactone (BLO) | 15.378 |
| Tetrahydrofuran (THF) | 15.105 |
| Resin in PGMEA/PGME (described in example 4) | 14.543 |
| Phosphoric acid (85%) | 0.067 |
| p-azo diphenylamine (PADA) | 0.025 |
| Diazo (US Patent 3,867,147) | 1.455 |
| Renol Blue Dispersion | 0.391 |

The shelf stability of this coating solution at room temperature was found to be more than 5 days. The LEL readings for this solution was in the range of 3-6%. The coating was applied at a coating weight of 1.0 g/m². The exposed and developed plates when put on a Multi press provided 250,000 printed impressions.

### Example 6

A degreased, etched, electrochemically grained using alternating current, anodized and sealed (with polyvinyl phosphonic acid) 1050 alloy was coated with a light sensitive coating. The light sensitive coating contained a diazo resin as described in U.S. Patents 3,867,147 and 3,849,392. The resin used is a modified polyvinyl acetal resin in PGMEA/PGME as described in example 4. The following coating solution was employed:

| Ingredient | Weight Percent |
|---|---|
| Propylene glycol methyl ether (Dowanol PM) | 46.297 |
| Butyrolactone (BLO) | 11.378 |
| Tetrahydrofuran (THF) | 25.117 |
| Resin in PGMEA/PGME (described in example 4) | 8.201 |
| Phosphoric acid (85%) | 0.062 |
| p-azo diphenylamine (PADA) | 0.020 |
| Diazo (US Patent 3,867,147) | 1.151 |
| Resin in PGMEA/PGME Blue Dispersion (example 4) | 7.774 |

The shelf stability of this coating solution at room temperature was found to be more than 5 days. The LEL readings for this solution was in the range of 3-6%. The coating was applied at a coating weight of 0.75 g/m². The exposed and developed plates when put on a Multi press provided 200,000 printed impressions.

## Claims

1. A method for the preparation of a modified polymer which is useful as a binder for photosensitive compositions, the method comprising dispersing a hydroxy containing polymer in a sufficient amount of a non-hydroxy containing solvent composition which is free of methyl ethyl ketone and ethylene glycol monomethyl ether, to uniformly disperse the hydroxy containing polymer under conditions such that the solvent composition does not emit an amount of combustible vapors, which when mixed with air exceeds 25 % of the lower explosive limit of the solvent composition; and reacting the hydroxy containing polymer with an anhydride in the presence of a catalytic amount of a tertiary amine catalyst.

2. The method of claim 1 wherein the modified polymer has an average molecular weight of from about 5,000 to about 200,000, and an acid number of from about 5 to about 80.

3. Method according to claim 1 or 2 wherein the hydroxy containing polymer has no further functional groups which are capable of reaction with acid anhydrides.

4. Method according to any of claims 1 to 3 wherein the hydroxy containing polymer is selected from the group consisting of one or more of epoxy resins, saponified epoxy resins, copolymers of unsaturated alcohols, polyhydroxyalkyl acrylates and polyhydroxyalkyl methacrylates.

5. Method according to any of claims 1 to 3 wherein the hydroxy containing polymer has vinyl alcohol moieties.

6. Method according to claim 5 wherein the hydroxy containing polymer is a copolymer of vinyl acetal, vinyl alcohol and vinyl acetate.

7. Method according to claim 5 wherein the hydroxy containing polymer is a polyvinyl butyral or polyvinyl formal.

8. Method according to claim 7 wherein the hydroxy containing polymer is a polyvinyl butyral which contains about 69-71 mol % vinyl acetal units, about 5 mol % vinyl acetate units and about 24-27 mol % vinyl alcohol units.

9. Method according to any of the preceding claims wherein the anhydride is an intramolecular anhydride of an organic polycarboxylic acid.

10. Method according to claim 9 wherein the anhydride is an acid anhydride corresponding to one of the Formulae I, II or III : 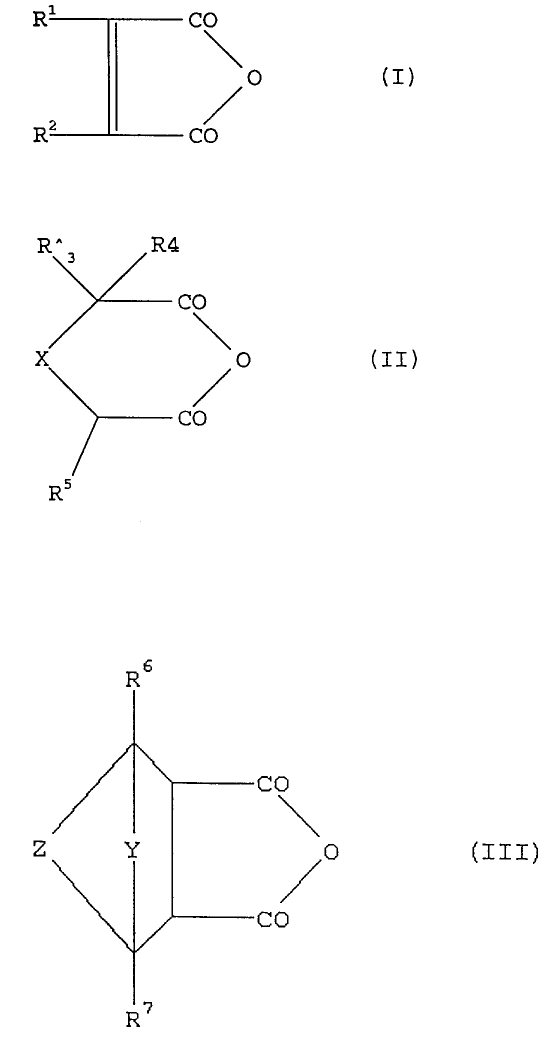 wherein
R1 and R2 are independently selected from hydrogen atoms and alkyl groups having from about 1 to about 4 carbon atoms, or are interconnected to form an aromatic or heteroaromatic, unsubstituted or substituted and may be partially hydrogenated five-membered or six-membered ring which may be fused with up to two aromatic or cycloaliphatic rings;
R3, R4 and R5 are independently selected from hydrogen atoms and alkyl groups having from about 1 to about 4 carbon atoms, and R3 and R5 may be interconnected to form an unsubstituted or substituted, saturated or unsaturated aliphatic ring which, inclusive of X, may have five or six ring members;
R6 and R7 are selected from hydrogen atoms and alkyl groups having from about 1 to about 4 carbon atoms;
X is a single bond, an unsubstituted or substituted 1,1-alkylene group or 1,1-cycloalkylene group, an oxygen atom or a sulfur atom;
Y is an oxygen atom or a sulfur atom, a 1,1- or 1,2-alkylene group or a 1,2-alkenylene group, which may be fused with an aromatic or cycloaliphatic ring; and
Z is selected from ring members required for the completion of a saturated or unsaturated, unsubstituted or substituted ring, which ring may be fused with up to two aromatic or cycloaliphatic rings.

11. Method according to any of the preceding claims wherein the reaction is conducted in the presence of a triethylamine catalyst.

12. The method of claim 1 wherein the hydroxy containing polymer is a polyvinyl butyral which contains about 69-71 mol % vinyl acetal units, about 5 mol % vinyl acetate units and about 24-27 mol % vinyl alcohol units, the anhydride is maleic anhydride, the catalyst is triethylamine and the non-hydroxy containing solvent composition comprises propylene glycol monomethyl ether acetate.

13. Method according to any the preceding claims further comprising the subsequent step of dissolving the modified polymer in a sufficient amount of a second solvent composition comprising propylene glycol monomethylether.

14. Method according to claim 13 wherein the second solvent composition comprises propylene glycol monomethylether acetate, propylene glycol monomethylether, tetrahydrofuran and butyrolacetone.

15. A method of producing a photosensitive composition which comprises
(a) forming a modified polymer according to any of claims 1 to 12,
(b) dissolving the formed modified polymer in a second solvent composition free of methyl ethyl ketone and ethylene glycol monomethyl ether, without isolation of the modified polymer, and
(c) uniformly admixing therewith at least one light sensitive component selected from the group consisting of a diazonium compound, a photopolymerizable composition, an azido compound or a quinonediazide compound to form a photosensitive composition.

16. The method of claim 15 wherein the solvent composition comprises an admixture of propylene glycol monomethylether acetate and propylene glycol monomethylether.

17. The method of claim 16 wherein the second solvent composition comprises an admixture of propylene glycol monomethylether acetate, propylene glycol monomethylether, tetrahydrofuran and butyrolacetone.

18. A method of producing a photosensitive element which comprises coating a photosensitive composition according to claim 15 onto a substrate and drying.

19. The method of claim 8 wherein the substrate comprises one or more materials selected from the group consisting of aluminium alloys, silicon and polymeric materials.

20. A method of producing a photographic image which comprises
(a) imagewise exposing a photosensitive element according to claim 18 or 19 to atonic radiation; and
(b) removing the nonimage portions of the photosensitive composition from the substrate while leaving the image portions of the photosensitive composition on the substrate.

21. The method of claim 20 wherein the nonimage portions of the photosensitive composition are removed with a developer composition selected from the group consisting of water, an aqueous solution comprising an inorganic salt, an aqueous solution comprising a surfactant, and an aqueous alkaline solution.
